# EUROPEAN PATENT APPLICATION

(11) **EP 4 614 566 A1**
(43) Date of publication of application: **10.09.2025**
(21) Application number: 23895655.1
(22) Date of filing: 01.02.2023
(51) Int. Cl.: H01L 23/48, H01L 23/10

(54) **TUBE SHELL FOR FULLY-CONTROLLED POWER ELECTRONIC DEVICE**

(30) Priority: 01.12.2022 CN 202211523235
(71) Applicant: TSINGHUA UNIVERSITY, Beijing, 100084 (CN)
(72) Inventor: WU, Jinpeng, Beijing 100084 (CN); ZENG, Rong, Beijing 100084 (CN); SHANG, Jie, Beijing 100084 (CN); CHEN, Zhengyu, Beijing 100084 (CN); ZHAO, Biao, Beijing 100084 (CN); YU, Zhanqing, Beijing 100084 (CN); LIU, Jiapeng, Beijing 100084 (CN); ZHUANG, Chijie, Beijing 100084 (CN)
(74) Representative: Meissner Bolte Partnerschaft mbB
(86) International application number: PCT/CN2023/074085
(87) International publication number: WO 2024/113479

(57) **Abstract**

Provided in the present disclosure is a tube shell for a fully-controlled power electronic device. The tube shell includes a shell, a lead-out structure, and a connection structure. The lead-out structure is arranged on the shell and is configured to lead out a cathode electrode and a gate electrode in the shell; the lead-out structure is of a layered structure having two or more layers; the lead-out structure includes at least two metal layers, the width of each metal layer being larger than or equal to the diameter of the shell; and the lead-out structure extends to one side of the shell and is close to the connection structure. The connection structure is arranged on one side of the shell, is connected to the lead-out structure, and is configured to be in detachable low-inductance connection with a driving unit for driving the fully-controlled power electronic device, where the detachable manner is an insertion-type or pressing-type non-rotary connection manner, so that the driving unit can be separated from the connection structure when pressure is applied to the shell. The lead-out structure and the connection structure both have stray inductance at a nanohenry level or below. The tube shell of the present disclosure is convenient to assemble and disassemble.

## Description

### TECHNICAL FIELD

The present disclosure belongs to the technical field of power electronics, and particularly relates to a tube shell for a fully-controlled power electronic device.

### BACKGROUND

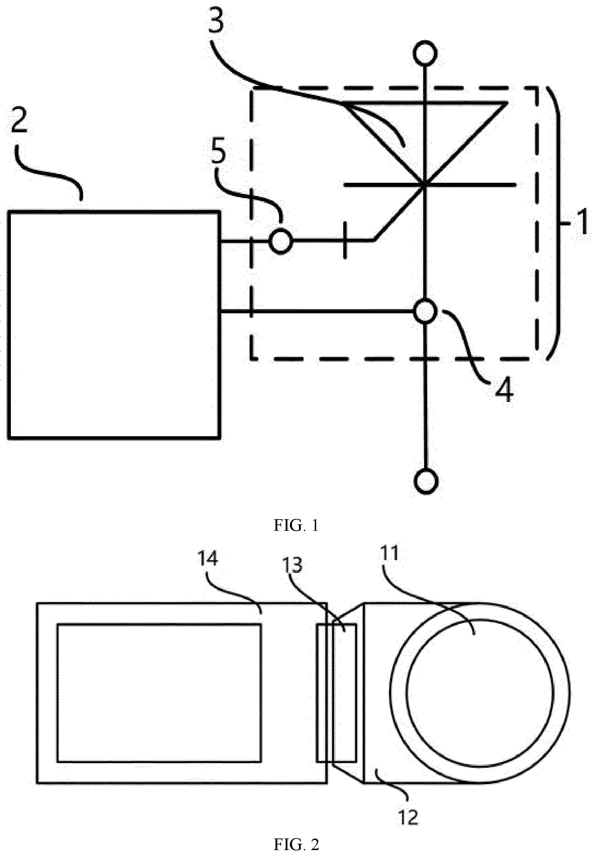

Fully-controlled power electronic devices are widely used in current transmission systems. Current type fully-controlled power electronic devices have the advantages of low break-over voltage drops and large surge currents, and are important in the fields of solid-state breakers, converters, and power electronic transformers. In some common devices, for example, in IGCT (integrated gate-commutated thyristor) devices, two parts, fully-controlled power electronic device elements and integrated gate driving circuits, are usually included. For example, in FIG. 1, a fully-controlled power electronic device element 1 is connected to a gate driving circuit 2, the fully-controlled power electronic device element 1 is composed of a fully-controlled power electronic device chip 3 and a tube shell (not shown), during turning-on triggering, the gate driving circuit 2 injects a trigger current of several hundreds of amperes to a gate 5 of the fully-controlled power electronic device chip 3, and the trigger current needs to have the relatively high di/dt to ensure uniform turning-on of the fully-controlled power electronic device chip 3. During turning-off, a current of a cathode 4 of the fully-controlled power electronic device chip 3 is forced by means of a negative-pressure circuit to be quickly commutated to the gate driving circuit (with the typical commutation time being about 1 us), so as to achieve the driving conditions for hard turning-off. Voltage type fully-controlled power electronic devices have the advantages of easy gate driving and flexible wiring, for example, only voltage control signals of +/-20 V are required to be supplied for driving IGBTs (insulated gate bipolar translators), and same can be flexibly connected to fully-controlled power electronic device elements through leads.

During turning-off, a current of an emitter needs to be quickly commutated to the gate, so that the current type fully-controlled power electronic device requires extremely small parasitic inductance in a commutation circuit between the gate driving circuit and the element (with the typical parameters being at nH level). To achieve this purpose, currently, driving circuit boards and tube shells of fully-controlled power electronic device elements of IGCTs and ETOs are connected in a screwed integrated manner. If the gate driving circuit breaks down during use, it cannot be directly disassembled or replaced, and the entire fully-controlled power electronic device must be disassembled from a press-fit assembly, which greatly increases the maintenance cost of the assembly. The patent CN 111900136 provides a design scheme for a device with a separate gate drive, the drive is conveniently disassembled from a tube shell by means of an accessory interface board of a special structure, and the accessory interface board is connected to the tube shell in the same manner as that of a traditional IGCT which cannot be directly disassembled. Tube shells of the existing fully-controlled power electronic devices (including the above patent) are in the shapes the same as round cake structures of traditional thyristors, and are simple in function and large in assembly difficulty, so that there is room for optimization.

Thus, a tube shell for a fully-controlled power electronic device can be designed, so as to solve the above technical problems.

### SUMMARY

To solve the above problems, the present disclosure provides a tube shell for a fully-controlled power electronic device.

The tube shell includes a shell, a lead-out structure, and a connection structure, where
the lead-out structure is arranged on the shell and is configured to lead out a cathode electrode and a gate electrode in the shell; the lead-out structure is of a layered structure having two or more layers; the lead-out structure includes at least two metal layers, the width of each metal layer being larger than or equal to the diameter of the shell; the lead-out structure extends to one side of the shell and is close to the connection structure;
the connection structure is arranged on one side of the shell, is connected to the lead-out structure, and is configured to be in detachable low-inductance connection with a driving unit for driving the fully-controlled power electronic device, where the detachable manner is an insertion-type or pressing-type non-rotary connection manner, so that the driving unit is capable of being separated from the connection structure when pressure is applied to the shell; and
the lead-out structure and the connection structure both have stray inductance at a nanohenry level or below.

Further, a gap is provided between the two metal layers, an insulating layer is arranged in the gap, and the insulating layer is configured to prevent short-circuiting between the metal layers;
each of the metal layers has the length of 5-100 mm, so that the connection structure is arranged on one side of the shell; each of the metal layers has a resistance of 50 uΩ-1 mΩ; each of the metal layers has inductance of 10-500 pH;
the insulating layer has the thickness of 1-500 um; and
the insulating layer includes, but is not limited to, any one of the following materials:
   a polymer film, a glass fiber cloth, a non-metallic oxide coating, and a non-metallic nitride coating.

Further, the lead-out structure is integrally connected to the shell.

Further, each of the metal layers is a metal sheet; in the two metal sheets:
one end of one of the metal sheets is integrally formed with the gate electrode in the shell, and one end of the other metal sheet is integrally formed with the cathode electrode in the shell; and
one or two of the metal sheets are bent outside the shell along an outer contour of the shell, a gap is provided between the two metal sheets after bending, an insulating layer is arranged in the gap, and the insulating layer is configured to prevent short-circuiting between the metal sheets.

Further,
the connection structure includes a fixing member and an insulating sheet, where
the insulating sheet is arranged on an outer side of one of the metal sheets;
one end of the driving unit is capable of being arranged between the two metal sheets;
positioning holes are formed in the insulating sheet and the other end of one of the metal sheets, and the positioning hole of the insulating sheet and the positioning hole of one of the metal sheets are matched with a positioning hole at one end of the driving unit;
a connection apparatus is arranged at the other end of the other metal sheet; and
the fixing member penetrates through the three positioning holes and is connected to the connection apparatus.

Further,
the lead-out structure is integrated on the shell.

Further,
each of the metal layers is a metal sheet; in the two metal sheets:
one end of one of the metal sheets is welded to the gate electrode in the shell, and one end of the other metal sheet is welded to the cathode electrode in the shell;
the other end of one of the metal sheets and the other end of the other metal sheet are both connected to the connection structure; and
one or two of the metal sheets are bent outside the shell along an outer contour of the shell, a gap is provided between the two metal sheets after bending, an insulating layer is arranged in the gap, and the insulating layer is configured to prevent short-circuiting between the metal sheets.

Further,
the lead-out structure is a laminated busbar, where the laminated busbar includes a first connection layer and a second connection layer, both the first connection layer and the second connection layer being made of metals;
one end of the first connection layer is welded to the gate electrode in the shell, and one end of the second connection layer is welded to the cathode electrode in the shell; or
one end of the first connection layer is connected to the gate electrode in the shell through a bolt, and one end of the second connection layer is connected to the cathode electrode in the shell through a bolt;
the other end of the first connection layer and the other end of the second connection layer are connected to the connection structure;
the width of the laminated busbar is larger than or equal to the diameter of the shell; and
the first connection layer and/or the second connection layer are/is bent outside the shell along an outer contour of the shell, a gap is provided between the two metal sheets after bending, an insulating layer is arranged in the gap, and the insulating layer is configured to prevent short-circuiting between the connection layers.

Further,
the lead-out structure is a printed circuit board, and one end of the printed circuit board is welded to the gate electrode and the cathode electrode in the shell, or one end of the printed circuit board is connected to the gate electrode and the cathode electrode in the shell through bolts;
the other end of the printed circuit board is connected to the connection structure;
the width of the printed circuit board is larger than or equal to the diameter of the shell; and
a gap is provided between copper layers of the printed circuit board, an insulating layer is arranged in the gap, and the insulating layer is configured to prevent short-circuiting between the copper layers.

Further,
the connection structure includes an upper fastening member, a lower fastening member, and a fixing member, where
the upper fastening member is arranged on an outer side of one of the metal sheets;
the lower fastening member is arranged on an outer side of the other metal sheet;
one end of the driving unit is capable of being arranged between the two metal sheets;
positioning holes are formed in the upper fastening member, the other end of one of the metal sheets and the other end of the other metal sheet;
the positioning hole of the upper fastening member, the positioning hole of one of the metal sheets and the positioning hole of the other metal sheet are matched with a positioning hole at one end of the driving unit;
a connection apparatus is arranged on the lower fastening member; and
the fixing member penetrates through the four positioning holes and is connected to the connection apparatus.

Further,
the fixing member is a bolt, and a threaded hole is formed in the connection apparatus.

Further,
the fixing member is a pressing rod, and each of the positioning holes and the connection apparatus includes a pressing structure.

According to the tube shell for the fully-controlled power electronic device in the present disclosure, the connection structure and the driving unit are configured to be detachably connected to each other, so that a gate driving circuit can be directly disassembled or replaced, and the operation is relatively convenient.

Other features and advantages of the present disclosure will be described in the following specification, and some will become obvious in the specification, or will be understood by implementing the present disclosure. The purposes and other advantages of the present disclosure can be achieved and obtained by means of the structures pointed out in the specification and the drawings.

### BRIEF DESCRIPTION OF THE DRAWINGS

To more clearly illustrate the technical solutions in the embodiments of the present disclosure or in the prior art, the accompanying drawings that need to be used in the description of the embodiments or the prior art will be briefly described below. Apparently, the accompanying drawings in the description below merely illustrate some embodiments of the present disclosure. Those of ordinary skill in the art may also derive other accompanying drawings from these accompanying drawings without creative efforts.
FIG. 1 illustrates a circuit diagram of an IGCT device in the prior art.
FIG. 2 illustrates a structural schematic diagram of a tube shell according to an embodiment of the present disclosure.
FIG. 3 illustrates a structural schematic diagram when one of the metal sheets of a lead-out structure is bent according to an embodiment of the present disclosure.
FIG. 4 illustrates a top view according to FIG. 3 of the present disclosure.
FIG. 5 illustrates a bottom view according to FIG. 3 of the present disclosure.
FIG. 6 illustrates a structural schematic diagram of a connection structure and a lead-out structure which are connected according to an embodiment of the present disclosure.
FIG. 7 illustrates one structural schematic diagram of a connection structure under the condition that a lead-out structure is integrally connected to a shell according to an embodiment of the present disclosure.
FIG. 8 illustrates a structural schematic diagram when a fixing member is a pressing rod under the condition that a lead-out structure is integrally connected to a shell according to an embodiment of the present disclosure.
FIG. 9 illustrates the other structural schematic diagram of a connection structure under the condition that a lead-out structure is integrally connected to a shell according to an embodiment of the present disclosure.
FIG. 10 illustrates a structural schematic diagram of a lead-out structure under the condition that the lead-out structure is integrated on a shell according to an embodiment of the present disclosure.
FIG. 11 illustrates a structural schematic diagram when a fixing member is a pressing rod under the condition that a lead-out structure is integrated on a shell according to an embodiment of the present disclosure.
FIG. 12 illustrates a structural schematic diagram when a lead-out structure is a laminated busbar under the condition that the lead-out structure is integrated on a shell according to an embodiment of the present disclosure.
FIG. 13 illustrates a structural schematic diagram of a laminated busbar according to an embodiment of the present disclosure.
FIG. 14 illustrates a structural schematic diagram when a lead-out structure is a printed circuit board under the condition that the lead-out structure is integrated on a shell according to an embodiment of the present disclosure.

### DETAILED DESCRIPTION OF EMBODIMENTS

In order to make the purposes, technical solutions and advantages of embodiments of the present disclosure clearer, the technical solutions in the embodiments of the present disclosure will be described clearly and completely below in conjunction with the accompanying drawings in the embodiments of the present disclosure. Obviously, the described embodiments are only a part of embodiments of the present disclosure, not all of them. On the basis of the embodiments of the present disclosure, all other embodiments obtained by those of ordinary skill in the art without involving any creative effort should fall within the scope of protection of the present disclosure.

In addition, in the present disclosure, the terms "first", "second" and other similar words are not intended to imply any order, quantity or importance, and are only intended to distinguish different elements.

As shown in FIG. 2, an embodiment of the present disclosure provides a tube shell for a fully-controlled power electronic device. The tube shell includes a shell 11, a lead-out structure 12, and a connection structure 13.

The lead-out structure 12 is arranged on the shell 11 and is configured to lead out a cathode electrode and a gate electrode in the shell; and the lead-out structure is of a layered structure having two or more layers with a large current (the current at a kA level) and low inductance (the inductance at a hundred-pH level).

The connection structure 13 is connected to the lead-out structure 12, and the lead-out structure and the connection structure both have a through-current capability at kA level or above and stray inductance at a nanohenry level or below.

The connection structure 13 is configured to be detachably connected to a driving unit 14 for driving the fully-controlled power electronic device.

In an embodiment, the detachable manner is an insertion-type or pressing-type non-rotary connection manner, so that the driving unit can be separated from the connection structure when pressure is applied to the shell.

In an embodiment, the lead-out structure 12 is of a layered structure having two or more layers; the lead-out structure 12 includes at least two metal layers, the width of each metal layer being larger than or equal to the diameter of the shell; and the lead-out structure 12 extends to one side of the shell 11 and is close to the connection structure 13.

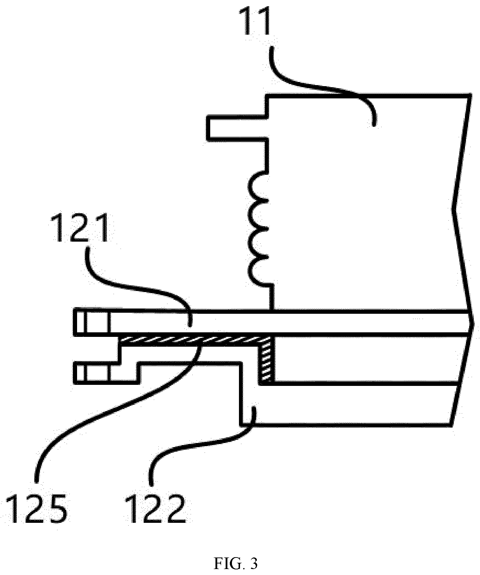

In an embodiment, as shown in FIG. 3,
the lead-out structure 12 includes at least two metal layers. In this embodiment, each of the metal layers is a metal sheet; there are two metal sheets,
the width of each of the two metal sheets being larger than or equal to the diameter of the shell; and
one of the two metal sheets is bent outside the shell along an outer contour of the shell, a gap is provided between the two metal sheets after bending, and an insulating layer is arranged in the gap. After the metal sheet is bent, the lower parasitic inductance and higher mechanical strength can be achieved.

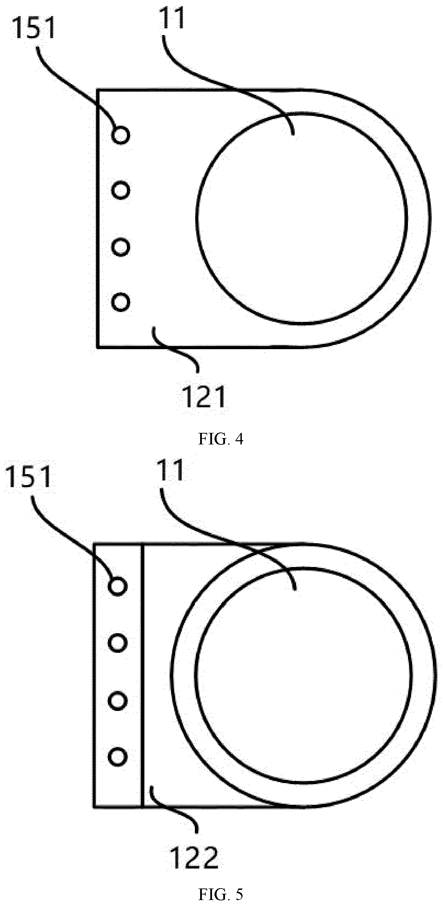

As shown in FIG. 4, FIG. 4 is a top view of FIG. 3, FIG. 5 is a bottom view of FIG. 3, and a plurality of positioning holes 151 are formed in the two metal sheets.

The lead-out structure further includes an insulating layer, the insulating layer being located between the two metal sheets and being configured to prevent short-circuiting between the metal sheets.

In the other aspect, in some embodiments of the present disclosure, the lead-out structure 12 is of a layered structure having two or more layers with a large current and low inductance. The specific structure of the lead-out structure 12 is as follows: through the alternate laminated arrangement of the metal layers and the insulating layer, the overall width of the lead-out structure 12 is larger than or equal to the diameter of the shell 11; and at least two metal layers are provided, each layer has the thickness of 50-500 um. In this embodiment, as shown in FIG. 3, the two metal layers are sheet-like, that is, the metal layers are metal sheets. One end of one metal sheet 122 is integrally formed with the gate electrode in the shell 11, and one end of the other metal sheet 121 is integrally formed with the cathode electrode in the shell 11. The width of each of the two metal sheets is larger than or equal to the diameter of the shell 11.

In the two metal sheets, the metal sheet 122 is bent outside the shell 11 along an outer contour of the shell 11 from the bottom of the shell 11 to the side edge of the shell 11, a gap (a first gap) is provided between the two metal sheets after bending, and an insulating layer 125 is arranged in the first gap. An end of the metal sheet 122 is bent in the middle of the metal sheet 122, a second gap is formed between the end of the metal sheet 122 and the other metal sheet 121, and the gap can be connected to the connection structure through the end of the metal sheet 122 and the end of the other metal sheet 121.

In addition, in this embodiment, the metal sheet 122 can also be not bent, that is, the two metal sheets are in straight plate shapes.

At least one insulating layer 125 is provided (the number is determined according to the number of the metal layers), and the thickness is 1-500 um; if two metal layers are provided, each of the gate electrode and the cathode electrode is connected to one of the two layers; and if more than two layers are provided, each of the gate electrode 111 and the cathode electrode 112 is connected to half of the multiple metal layers that are alternate (that is, the gate electrode 111 is connected to the first/third/fifth...layers, and the cathode electrode 112 is connected to the second/fourth/sixth...layers).

The metal layers are usually made of copper, so as to obtain the sufficient through-current capability. Assuming that each copper layer has the thickness of 100 um, the width of 150 mm (that is, the sectional area of each metal layer is also 150 mm), and the length of 50 mm, the resistance can be obtained according to the following formula: R=ρL/S, where L is the length of the metal layer, ρ is the resistivity of the metal layer (for example, 1.75E-8), and S is the sectional area of the metal layer.

Then the resistance of the metal layer is as follows: R=1.75E-8*0.05/(0.15*1E-4)=58.3uQ; and if the through-current amount of the metal layer is 10 kA, the voltage drop is 0.58 V, which completely meets the requirements of a GCT device and the driving unit 14 for the through-current capability of the tube shell (the voltage drop is generally smaller than 5 V).

The insulating layer 125 can be realized by using different processes and materials. The insulating layer 125 specifically includes, but is not limited to, any one of the following materials: a polymer film (having the thickness of 20-200 um), a glass fiber cloth (100-500 um), a non-metallic oxide coating (1-50 um), and a non-metallic nitride coating (1-50 um). Different process methods are used to realize the insulation between the different metal layers. Particularly, the insulating voltage between the two metal layers does not exceed 30 V, and all the above methods can meet the requirements.

To meet the requirements of the GCT device and the drive for the parasitic inductance of the tube shell, the thickness of the insulating layer 125 should be as small as possible (that is, 500 um or below). A finite element simulation (FEM) means is used to simulate the parasitic inductance of two metal plates (with the length of 10 mm, the width of 150 mm, and the thickness of 500 um) with a spacing of 300 um, and the parasitic inductance is about 300 pH. According to the electrical knowledge, it can be seen that the smaller the spacing between the two plates is, the lower the parasitic inductance is; the larger the number of the parallel plates is, the lower the parasitic inductance is; and the smaller the length of the plates is, the lower the parasitic inductance is. Thus, this embodiment aims to reduce the parasitic inductance (by means of reducing the spacing, increasing the number of layers, and shortening the plates) on the premise of meeting the through-current capability of the metal layers, thereby achieving the better electrical performance.

In the present disclosure, the fully-controlled power electronic device can be any one of an IGCT, an emitter turn-off thyristor (ETO) and a super-gate turn-off thyristor (SGTO). In this embodiment, the IGCT device is taken as an example for illustrative description.

When the fully-controlled power electronic device is the IGCT device, the driving unit 14 is a part of the IGCT device, a fully-controlled power electronic device chip included in the corresponding IGCT device is a GCT chip, the GCT chip is arranged in the shell 11, a gate of the GCT chip is connected to the gate electrode in the shell 11, a cathode of the GCT chip is connected to the cathode electrode in the shell 11, a driving circuit is arranged in the driving unit 14, and the driving circuit can be used to drive the GCT chip to be turned on or turned off.

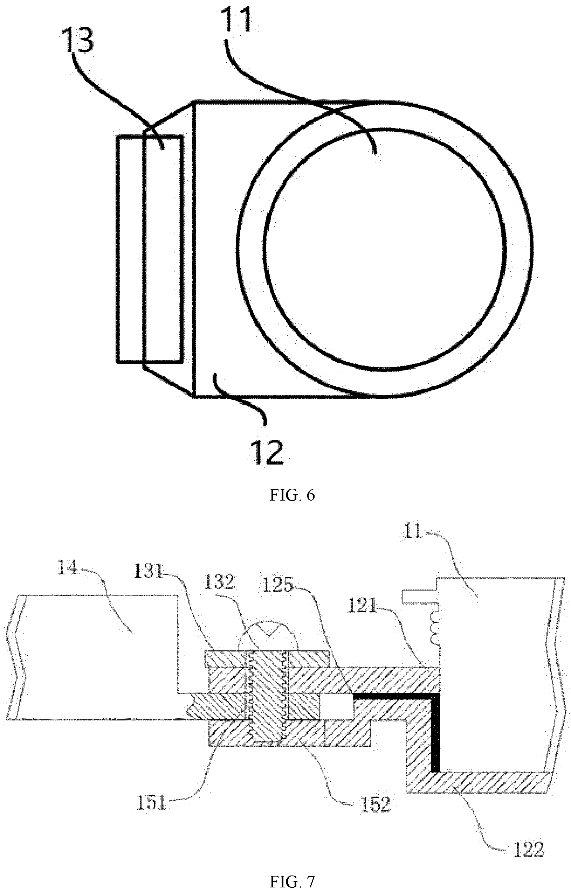

In an embodiment of the present disclosure, for the connection relationship between the connection structure 13 and the lead-out structure 12, for example, as shown in FIG. 6, the lead-out structure 12 is integrally connected to the shell 11, or the lead-out structure 12 is integrated on the shell 11.

The detailed description is provided below.

### The lead-out structure being integrally connected to the shell

Under the condition that the lead-out structure 12 is integrally connected to the shell 11, the lead-out structure 12 includes at least two metal layers, where the metal layers are metal sheets, two metal sheets are provided, one is a gate metal sheet 121, the other is a cathode metal sheet 122, and
materials of the two metal sheets can be selected as required, for example, they may be copper sheets.

One end of one of the metal sheets (that is, the gate metal sheet 121) is integrally formed with the gate electrode in the shell 11; and
one end of the other metal sheet (that is, the cathode metal sheet 122) is integrally formed with the cathode electrode in the shell 11. The cathode metal sheet 122 is in a shape the same as that in FIG. 7.

Through the integrated connection manner in which the two metal sheets are integrally formed with the gate electrode and the cathode electrode in the shell 11, the lead-out structure 12 and the shell 11 can form a whole.

For the connection structure 13, one end of the connection structure 13 can be two copper sheets integrally formed with the lead-out structure 12, and the polymer film or the non-metallic oxide film is used between the two copper sheets for insulation. In this embodiment, at this moment, the cathode metal sheet 122 is bent outside the shell 11 along the outer contour of the shell 11 to realize the minimum spacing, thereby reducing the parasitic inductance. The machining difficulty is small, the integration level is high, and meanwhile, the driving unit 14 can be conveniently and flexibly disassembled. The other end of the connection structure 13 is in insertion-type connection with the driving unit 14, for example, the connection structure 13 may be in a plate shape, the upper surface of the connection structure 13 is provided with a first electrical connection end (which is electrically conductive), the lower surface of the connection structure 13 is provided with a second electrical connection end (which is electrically conductive), the other end of the gate metal sheet 121 is integrally formed with the first electrical connection end, and the other end of the cathode metal sheet 122 is integrally formed with the second electrical connection end; at this moment, the other end of the connection structure 13 can be in insertion-type connection with the driving unit 14, that is, the other end of the connection structure 13 can be inserted into an insertion hole of the driving unit 14; and after the other end of the connection structure 13 is inserted into the insertion hole of the driving unit 14, the first electrical connection end is in contact with a gate contact in the insertion hole, and the second electrical connection end is in contact with a cathode contact in the insertion hole.

For the connection structure 13, in an embodiment of the present disclosure, the connection structure 13 can also be detachably connected to the lead-out structure 12, and meanwhile, the connection structure 13 is in non-insertion-type connection with the driving unit 14, for example, the following structures can be adopted (selected at will):
A1: as shown in FIG. 7, in an embodiment, the connection structure 13 can include a fixing member 132 and an insulating gasket 131, where
the insulating gasket 131 is arranged on the outer side of the gate metal sheet 121 (the upper side of the gate metal sheet 121 in FIG. 7);
one end of the driving unit 14 is arranged between the two metal sheets 121 (in FIG. 7, the cathode metal sheet 122 is located below the gate metal sheet 121);
positioning holes (the number of which can be set as required) are formed in the insulating gasket 131 and the other end of the gate metal sheet 121;
the positioning hole of the insulating gasket 131 and the positioning hole of the gate metal sheet 121 are matched with a positioning hole at one end of the driving unit 14;
a connection apparatus is arranged at the other end of the cathode metal sheet 122; and
the fixing member 132 penetrates through the three positioning holes (that is, first positioning holes 151 in FIG. 7) and is connected to the connection apparatus (that is, a first connection apparatus 152 in FIG. 7).

In this embodiment, the fixing member 132 may be a bolt, and a threaded hole is formed in the connection apparatus, so that after the fixing member 132 sequentially and rotationally enters the positioning hole of the insulating gasket 131, the positioning hole at the other end of the gate metal sheet 121 and the positioning hole at one end of the driving unit 14, it rotationally enters the threaded hole in the connection apparatus, and then the driving unit 14, the connection structure 13 and the shell 11 can be connected to one another. In this embodiment, the specific structure of the connection apparatus can be configured as required, for example, it may be in a plate shape, which is directly machined on the cathode metal sheet 122. After the bottom of the fixing member 132 rotationally enters the threaded hole in the connection apparatus, the insulating gasket 131, the gate metal sheet 121, the cathode metal sheet 122 and one end of the driving unit 14 can be pressed together.

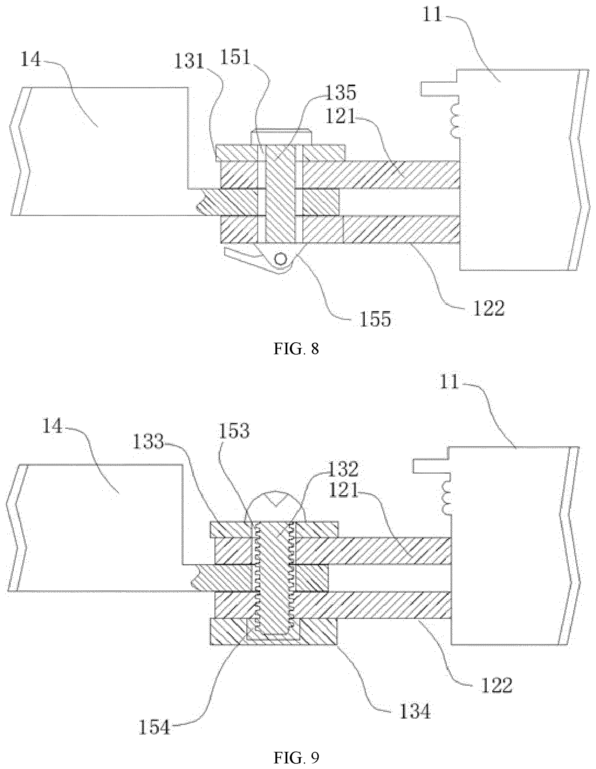

In addition, in this embodiment, as shown in FIG. 8, the fixing member 132 may also be a pressing rod 135 (the pressing rod 135 is T-shaped), then the connection apparatus has no threaded hole, but includes a pressing structure 155, and the pressing structure 155 can be connected to the bottom of the pressing rod 135 and is configured to press the insulating gasket 131, the gate metal sheet 121, the cathode metal sheet 122 and one end of the driving unit 14 together.

In FIG. 7 and FIG. 8, the gate contact (not shown in FIG. 7 and FIG. 8) is arranged on the upper surface of one end of the driving unit 14, the cathode contact (not shown in FIG. 7 and FIG. 9) is arranged on the lower surface of one end of the driving unit 14, the gate contact can be in contact with the gate metal sheet 121, and the cathode contact can be in contact with the connection apparatus on the cathode metal sheet 122. By means of the gate contact and the cathode contact, the driving unit 14 can be in communication with the GCT chip.

A2: as shown in FIG. 9, in another embodiment, the connection structure 13 includes an upper fastening member 133 (for example, it may be in a plate shape), a lower fastening member 134, and a fixing member 132 (for example, it may be in a plate shape), where
the upper fastening member 133 is arranged on the outer side of the gate metal sheet 121 (the upper side of the gate metal sheet 121 in FIG. 9);
the lower fastening member 134 is arranged on the outer side of the cathode metal sheet 122 (in FIG. 9, the cathode metal sheet 122 is located below the gate metal sheet 121);
one end of the driving unit 14 is arranged between the two metal sheets 121;
positioning holes (that is, second positioning holes 153 in FIG. 9) are formed in the upper fastening member 133, the other end of the gate metal sheet 121 and the other end of the cathode metal sheet 122;
the positioning hole of the upper fastening member 133, the positioning hole of the gate metal sheet 121 and the positioning hole of the cathode metal sheet 122 are matched with a positioning hole at one end of the driving unit 14;
a connection apparatus (that is, a second connection apparatus 154 in FIG. 9) is arranged on the lower fastening member 134; and
the fixing member 132 penetrates through the four positioning holes and is connected to the connection apparatus.

In this embodiment, the fixing member 132 may be a bolt, and a threaded hole is formed in the connection apparatus, so that after the fixing member 132 sequentially and rotationally enters the positioning hole of the upper fastening member 133, the positioning hole at the other end of the gate metal sheet 121, the positioning hole at one end of the driving unit 14 and the positioning hole at the other end of the cathode metal sheet 122, it rotationally enters the threaded hole in the connection apparatus, and then the driving unit 14, the connection structure 13 and the shell 11 can be connected to one another.

In addition, in this embodiment, the fixing member 132 may also be the pressing rod 135 mentioned above, and then the positioning holes and the connection apparatus include the pressing structures 155 (not shown) mentioned above.

In FIG. 9, the gate contact (not shown in FIG. 9) is also arranged on the upper surface of one end of the driving unit 14, the cathode contact (not shown in FIG. 9) is also arranged on the lower surface of one end of the driving unit 14, the gate contact can be in contact with the gate metal sheet 121, and the cathode contact can be in direct contact with the cathode metal sheet 122. By means of the gate contact and the cathode contact, the driving unit 14 can be in communication with the GCT chip.

In an embodiment of the present disclosure, for the structure of the lead-out structure below, the two metal sheets in the lead-out structure are each in a straight plate shape, which is explained in detail below.

### The lead-out structure being integrated on the shell

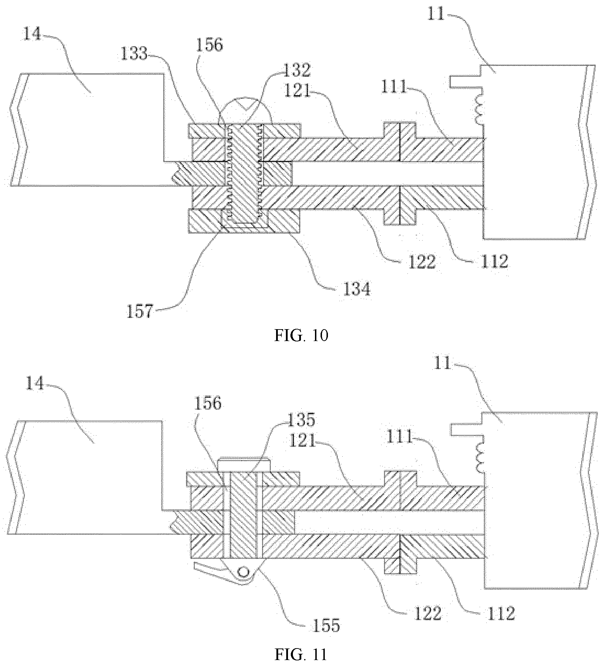

Under the condition that the lead-out structure 12 is integrated on the shell 11, as shown in FIG. 10, the lead-out structure 12 includes at least two metal layers, where the metal layers are metal sheets, in two metal sheets, similarly, one is a gate metal sheet 121, and the other is a cathode metal sheet 122;
one end of the gate metal sheet 121 is welded to the gate electrode 111 in the shell 11;
one end of the cathode metal sheet 122 is welded to the cathode electrode 112 in the shell 11; and
the other end of the gate metal sheet 121 and the other end of the cathode metal sheet 122 are both connected to the connection structure 13.

For the connection structure 13, the connection structure 13 may also include an upper fastening member 133, a lower fastening member 134, and a fixing member 132, where
the upper fastening member 133 is arranged on the outer side of the gate metal sheet 121 (the upper side of the gate metal sheet 121 in FIG. 10);
the lower fastening member 134 is arranged on the outer side of the cathode metal sheet 122 (the lower side of the cathode metal sheet 122 in FIG. 10);
one end of the driving unit 14 is arranged between the two metal sheets 121;
positioning holes (that is, third positioning holes 156 in FIG. 10) are formed in the upper fastening member 133, the other end of the gate metal sheet 121 and the other end of the cathode metal sheet 122;
the positioning hole of the upper fastening member 133, the positioning hole of the metal sheet 121 and the positioning hole of the cathode metal sheet 122 are matched with a positioning hole at one end of the driving unit 14;
a connection apparatus (that is, a third connection apparatus 157 in FIG. 10) is arranged on the lower fastening member 134; and
the fixing member 132 penetrates through the four positioning holes and is connected to the connection apparatus.

In this embodiment, the fixing member 132 may be a bolt, and a threaded hole is formed in the connection apparatus, so that after the fixing member 132 sequentially and rotationally enters the positioning hole of the upper fastening member 133, the positioning hole at the other end of the gate metal sheet 121, the positioning hole at one end of the driving unit 14 and the positioning hole at the other end of the cathode metal sheet 122, it rotationally enters the threaded hole in the connection apparatus, and then the driving unit 14, the connection structure 13 and the shell 11 can be connected to one another.

In FIG. 10, the gate contact (not shown in FIG. 10) is arranged on the upper surface of one end of the driving unit 14, the cathode contact (not shown in FIG. 10) is arranged on the lower surface of one end of the driving unit 14, the gate contact can be in contact with the gate metal sheet 121, and the cathode contact can be in direct contact with the cathode metal sheet 122. By means of the gate contact and the cathode contact, the driving unit 14 can be in communication with the GCT chip.

In addition, in this embodiment, as shown in FIG. 11, the fixing member 132 may also be a pressing rod 135, then the connection apparatus is directly machined from the cathode metal sheet 122, and the connection apparatus also includes the pressing structure 155 mentioned above. In addition, the gate contact (not shown in FIG. 11) is arranged on the upper surface of one end of the driving unit 14, the cathode contact (not shown in FIG. 11) is arranged on the lower surface of one end of the driving unit 14, the gate contact can be in contact with the gate metal sheet 121, and the cathode contact can be in contact with the connection apparatus on the cathode metal sheet 122. By means of the gate contact and the cathode contact, the driving unit 14 can be in communication with the GCT chip.

Under the condition that the lead-out structure 12 is integrated on the shell 11, the lead-out structure 12 can also be of the following specific structures:

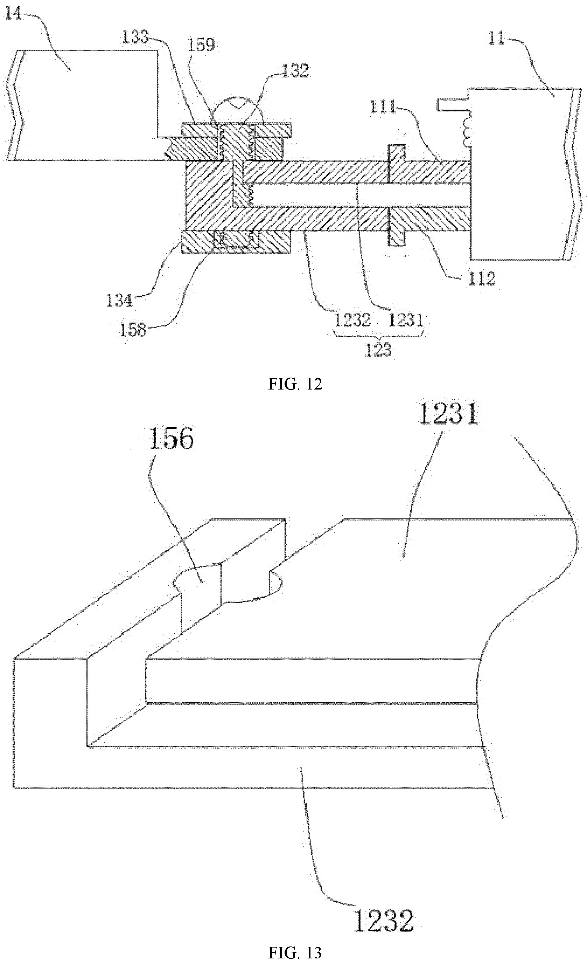

B1: as shown in FIG. 12, the lead-out structure is a laminated busbar 123, where
the laminated busbar 123 includes a first connection layer 1231 and a second connection layer 1232, both the first connection layer and the second connection layer being made of metals; the width of the laminated busbar 123 is larger than or equal to the diameter of the shell 11; and the first connection layer and/or the second connection layer are/is bent outside the shell 11 along an outer contour of the shell 11, a gap is provided between the two metal sheets after bending, an insulating layer is arranged in the gap, and the insulating layer is configured to prevent short-circuiting between the connection layers (that is, the first connection layer 1231 and the second connection layer 1232);
the first connection layer 1231 is in a straight plate shape, and the second connection layer 1232 is L-shaped; one end of the first connection layer 1231 is welded to the gate electrode 111 in the shell, and one end (a horizontal portion) of the second connection layer 1232 is welded to the cathode electrode 112 in the shell; or
one end of the first connection layer 1231 is connected to the gate electrode 111 in the shell through a bolt, and one end of the second connection layer 1232 is connected to the cathode electrode 112 in the shell through a bolt; and the other end of the first connection layer 1231 and the other end (a vertical portion) of the second connection layer 1232 are connected to the connection structure 13.

The gate contact (not shown in FIG. 12) is arranged on the lower surface of one end of the driving unit 14, and the cathode contact (not shown in FIG. 12) is arranged on the lower surface of one end of the driving unit 14.

A passage is arranged on the first connection layer 1231, one end of the passage is connected to the gate electrode 111, and the other end thereof is connected to the gate contact; a passage is further arranged on the second connection layer 1232, one end of the passage is connected to the cathode electrode 112, and the other end thereof is connected to the cathode contact. A gap exists between the first connection layer 1231 and the second connection layer 1232, the laminated busbar 123 further includes an insulating layer, and the insulating layer is located in the gap between the two connection layers and is configured to prevent short-circuiting between the connection layers.

The other end of the first connection layer 1231 and the other end (a vertical portion) of the second connection layer 1232 are connected to the connection structure 13, specifically,
the connection structure 13 may include a fixing member 132, an upper fastening member 133, and a lower fastening member 134, the fixing member 132 may be a bolt, a connection apparatus (that is, a fourth connection apparatus 158 in FIG. 12) is arranged on the lower fastening member 134, the upper surface of one end of the driving unit 14 is in contact with the lower surface of the upper fastening member 133,
the lower surface of one end of the driving unit 14 is in contact with the upper surface of one end of the first connection layer 1231 and the upper surface of one end of the second connection layer 1232, the lower fastening member 134 is located below the second connection layer 1232, and positioning holes (that is, fourth positioning holes 159 in FIG. 12) can be formed in one end of the driving unit 14, the upper fastening member 133, the first connection layer 1231, the second connection layer 1232 and the lower fastening member 134; as shown in FIG. 13, the positioning hole of the second connection layer 1232 is formed in a horizontal portion of the second connection layer 1232 and extends from the horizontal portion of the second connection layer 1232 to the vertical portion of the second connection layer 1232, and the inner surface of the positioning hole in the vertical portion is a cambered surface; and the positioning hole of the first connection layer 1231 is formed in the end surface of one end of the first connection layer 1231, and the inner surface of the positioning hole is also a cambered surface.

After sequentially penetrating through the positioning hole of the upper fastening member 133 and the positioning hole in one end of the driving unit 14, the fixing member 132 can simultaneously penetrate through the positioning holes in the first connection layer 1231 and the second connection layer 1232, and then is screwed into a threaded hole in the fourth connection apparatus 158.

In this embodiment, the polymer film is used between the first connection layer 1231 and the second connection layer 1232 for insulation, the minimum distance is achieved by means of a laminated busbar machining process, and meanwhile, the contact connection with a single surface of the driving unit 14 is achieved, so that the integration degree is high, the connection structure is simple, and the driving unit 14 can be conveniently and flexibly disassembled.

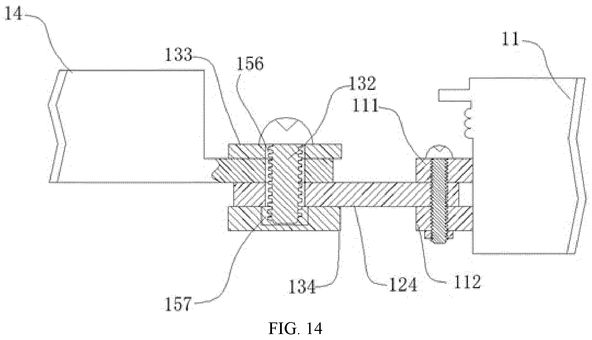

B2: as shown in FIG. 14, the lead-out structure is a printed circuit board 124, and one end of the printed circuit board 124 is welded to (or integrally formed with) the gate electrode 111 and the cathode electrode 112 in the shell 11, or one end of the printed circuit board 124 is connected to the gate electrode 111 and the cathode electrode 112 in the shell 11 through bolts;
the other end of the printed circuit board 124 is connected to the connection structure 13, the width of the printed circuit board 124 is larger than or equal to the diameter of the shell 11, an extremely small gap (at the level of dozens of um to hundreds of um) is provided between copper layers, an insulating layer is arranged in the gap, the insulating layer is configured to prevent short-circuiting between the copper layers, and then any one of the connection structures 13 mentioned above can be used; for example:
the connection structure 13 may include the upper fastening member 133, the lower fastening member 134, and the fixing member 132, where
the upper fastening member 133 is arranged above one end of the driving unit 14, the printed circuit board 124 is arranged below one end of the driving unit 14, and the lower fastening member 134 is arranged below the printed circuit board 124;
positioning holes (that is, the third positioning holes 156 in FIG. 14) are formed in the upper fastening member 133 and the printed circuit board 124;
the positioning hole of the upper fastening member 133 and the positioning hole of printed circuit board 124 are matched with the positioning hole at one end of the driving unit 14;
the connection apparatus (that is, the third connection apparatus 157 in FIG. 14) is arranged on the lower fastening member 134; and
the fixing member 132 penetrates through the three positioning holes and is connected to the connection apparatus.

In this embodiment, the fixing member 132 may be a bolt, and a threaded hole is formed in the connection apparatus, so that after the fixing member 132 sequentially and rotationally enters the positioning hole of the upper fastening member 133, the positioning hole at one end of the driving unit 14 and the positioning hole of the printed circuit board 124, it rotationally enters the threaded hole in the connection apparatus, and then the driving unit 14, the connection structure 13 and the shell 11 can be connected to one another.

The gate contact (not shown in FIG. 14) and the cathode contact (not shown in FIG. 14) are arranged on the lower surface of one end of the driving unit 14.

For the printed circuit board 124, two passages laid by a copper material are arranged on the printed circuit board 124; one end of one of the passages is in contact with the gate metal sheet 121, the other end thereof is in contact with the gate contact; and one end of the other passage is in contact with the cathode metal sheet 122, and the other end thereof is in contact with the cathode contact.

In this embodiment, the connection structure may also be a multi-layer circuit board integrated with the tube shell, a glass fiber cloth is used between the multi-layer circuit board for insulation, the minimum distance is achieved by means of the multi-layer circuit board, and meanwhile, the contact connection with a single surface of a driving plate is achieved, so that the parasitic inductance is very low, the connection structure is simple, and meanwhile, the driving unit 14 can be conveniently and flexibly disassembled.

Compared with an existing separated driving plate based on a flexible circuit board, the present disclosure has great improvements in through-current capability, parasitic inductance and overall integration, overcomes the defects of insufficient mechanical strength of the flexible printed circuit and large parasitic inductance at the joints with the tube shell and the driving plate, and has technical advancements.

It should be noted that although the present disclosure has been described in detail with reference to the foregoing embodiments, those of ordinary skill in the art should understand that it is still possible to modify the technical solutions described in the foregoing embodiments, or to replace partial technical features with equivalents. However, these modifications or replacements do not make the essence of the corresponding technical solutions deviate from the spirit and scope of the technical solutions of various embodiments of the present disclosure.

## Claims

1. A tube shell for a fully-controlled power electronic device, **characterized in that**
the tube shell comprises a shell, a lead-out structure, and a connection structure, wherein
the lead-out structure is arranged on the shell and is configured to lead out a cathode electrode and a gate electrode in the shell; the lead-out structure is of a layered structure having two or more layers; the lead-out structure comprises at least two metal layers, a width of each metal layer being larger than or equal to a diameter of the shell; the lead-out structure extends to one side of the shell and is close to the connection structure;
the connection structure is arranged on one side of the shell, is connected to the lead-out structure, and is configured to be in low-inductance connection in a detachable manner with a driving unit for driving the fully-controlled power electronic device, wherein the detachable manner is an insertion-type or pressing-type non-rotary connection manner, so that the driving unit is capable of being separated from the connection structure when pressure is applied to the shell; and
the lead-out structure and the connection structure both have stray inductance at a nanohenry level or below.

2. The tube shell for a fully-controlled power electronic device according to claim 1, **characterized in that** a gap is provided between the two metal layers, an insulating layer is arranged in the gap, and the insulating layer is configured to prevent short-circuiting between the metal layers;
each of the metal layers has a length of 5-100 mm, so that the connection structure is arranged on one side of the shell; each of the metal layers has a resistance of 50 uΩ-1 mΩ; each of the metal layers has inductance of 10-500 pH;
the insulating layer hasa thickness of 1-500 um; and
the insulating layer comprises, but is not limited to, any one of following materials:
a polymer film, a glass fiber cloth, a non-metallic oxide coating, and a non-metallic nitride coating.

3. The tube shell for a fully-controlled power electronic device according to claim 2, **characterized in that** the lead-out structure is integrally connected to the shell.

4. The tube shell for a fully-controlled power electronic device according to claim 1, **characterized in that** each of the metal layers is a metal sheet; in the two metal sheets:
one end of one of the metal sheets is integrally formed with the gate electrode in the shell, and one end of the other metal sheet is integrally formed with the cathode electrode in the shell; and
one or two of the metal sheets are bent outside the shell along an outer contour of the shell, a gap is provided between the two metal sheets after bending, an insulating layer is arranged in the gap, and the insulating layer is configured to prevent short-circuiting between the metal sheets.

5. The tube shell for a fully-controlled power electronic device according to claim 4, **characterized in that**
the connection structure comprises a fixing member and an insulating sheet, wherein
the insulating sheet is arranged on an outer side of one of the metal sheets;
one end of the driving unit is capable of being arranged between the two metal sheets;
positioning holes are formed in the insulating sheet and the other end of one of the metal sheets, and the positioning hole of the insulating sheet and the positioning hole of one of the metal sheets are matched with a positioning hole at one end of the driving unit;
a connection apparatus is arranged at the other end of the other metal sheet; and
the fixing member penetrates through the three positioning holes and is connected to the connection apparatus.

6. The tube shell for a fully-controlled power electronic device according to claim 2, **characterized in that**
the lead-out structure is integrated on the shell.

7. The tube shell for a fully-controlled power electronic device according to claim 6, **characterized in that**
each of the metal layers is a metal sheet; in the two metal sheets:
one end of one of the metal sheets is welded to the gate electrode in the shell, and one end of the other metal sheet is welded to the cathode electrode in the shell;
the other end of one of the metal sheets and the other end of the other metal sheet are both connected to the connection structure; and
one or two of the metal sheets are bent outside the shell along an outer contour of the shell, a gap is provided between the two metal sheets after bending, an insulating layer is arranged in the gap, and the insulating layer is configured to prevent short-circuiting between the metal sheets.

8. The tube shell for a fully-controlled power electronic device according to claim 6, **characterized in that**
the lead-out structure is a laminated busbar, wherein the laminated busbar comprises a first connection layer and a second connection layer, both the first connection layer and the second connection layer being made of metals;
one end of the first connection layer is welded to the gate electrode in the shell, and one end of the second connection layer is welded to the cathode electrode in the shell; or
one end of the first connection layer is connected to the gate electrode in the shell through a bolt, and one end of the second connection layer is connected to the cathode electrode in the shell through a bolt;
the other end of the first connection layer and the other end of the second connection layer are connected to the connection structure;
a width of the laminated busbar is larger than or equal to the diameter of the shell; and
the first connection layer and/or the second connection layer are/is bent outside the shell along an outer contour of the shell, a gap is provided between the two metal sheets after bending, an insulating layer is arranged in the gap, and the insulating layer is configured to prevent short-circuiting between the connection layers.

9. The tube shell for a fully-controlled power electronic device according to claim 6, **characterized in that**
the lead-out structure is a printed circuit board, and one end of the printed circuit board is welded to the gate electrode and the cathode electrode in the shell, or one end of the printed circuit board is connected to the gate electrode and the cathode electrode in the shell through bolts;
the other end of the printed circuit board is connected to the connection structure; a width of the printed circuit board is larger than or equal to the diameter of the shell; and
a gap is provided between copper layers of the printed circuit board, an insulating layer is arranged in the gap, and the insulating layer is configured to prevent short-circuiting between the copper layers.

10. The tube shell for a fully-controlled power electronic device according to claim 7, **characterized in that**
the connection structure comprises an upper fastening member, a lower fastening member, and a fixing member, wherein
the upper fastening member is arranged on an outer side of one of the metal sheets;
the lower fastening member is arranged on an outer side of the other metal sheet; one end of the driving unit is capable of being arranged between the two metal sheets;
positioning holes are formed in the upper fastening member, the other end of one of the metal sheets and the other end of the other metal sheet;
the positioning hole of the upper fastening member, the positioning hole of one of the metal sheets and the positioning hole of the other metal sheet are matched with a positioning hole at one end of the driving unit;
a connection apparatus is arranged on the lower fastening member; and
the fixing member penetrates through the four positioning holes and is connected to the connection apparatus.

11. The tube shell for a fully-controlled power electronic device according to claim 10, **characterized in that**
the fixing member is a bolt, and a threaded hole is formed in the connection apparatus.

12. The tube shell for a fully-controlled power electronic device according to claim 10, **characterized in that**
the fixing member is a pressing rod, and each of the positioning holes and the connection apparatus comprises a pressing structure.
